# EUROPEAN PATENT APPLICATION

(11) **EP 4 765 193 A1**
(43) Date of publication of application: **24.06.2026**
(21) Application number: 23949185.5
(22) Date of filing: 17.08.2023
(51) Int. Cl.: H01L 21/304, H01L 21/02, H01L 21/20

(54) **SEMICONDUCTOR WAFER PROVIDING METHOD AND SEMICONDUCTOR WAFER PROVIDING SYSTEM**

(71) Applicant: NGK Insulators, Ltd., Nagoya-shi, Aichi 467-8530 (JP)
(72) Inventor: MATSUSHIMA, Kiyoshi, Nagoya-shi, Aichi 467-8530 (JP); YOSHIKAWA, Jun, Nagoya-shi, Aichi 467-8530 (JP)
(74) Representative: Müller-Boré & Partner Patentanwälte PartG mbB
(86) International application number: PCT/JP2023/029687
(87) International publication number: WO 2025/037417

(57) **Abstract**

A semiconductor wafer providing method performed by a first entity includes: an acquisition step of acquiring a remaining wafer from a second entity; a fabrication step of fabricating a slice surface of the remaining wafer; a growth step of causing a semiconductor crystal layer to grow on the fabricated surface of the remaining wafer; and a wafer providing step of providing a new semiconductor wafer having at least part of the semiconductor crystal layer, which has grown on the fabricated surface of the remaining wafer, to a second entity which is the same as or different from the second entity that is an acquisition source of the remaining wafer.

## Description

### TECHNICAL FIELD

The present invention generally relates to provision of semiconductor wafers.

### BACKGROUND ART

In general, in the process of cutting a semiconductor wafer into a plurality of semiconductor chips, a device (such as electrodes and wiring patterns) is formed on a surface of the semiconductor wafer and a back side of the semiconductor wafer is ground in order to make the semiconductor wafer thinner (for example, PTL 1).

### CITATION LIST

### PATENT LITERATURE

PTL 1: Japanese Patent Application Laid-Open (Kokai) Publication No. 2022-66988

### SUMMARY OF THE INVENTION

### PROBLEMS TO BE SOLVED BY THE INVENTION

Ground scraps are produced by grinding the back side of the semiconductor wafer and the ground scraps are discarded.

Then, in general, the thickness of the semiconductor wafer is reduced to half or less than half of the original thickness, so that half or more than half of the semiconductor wafer becomes the ground scraps (for example, when the thickness of the semiconductor wafer is reduced from 350 µm to 100 µm, 70% or more becomes the ground scraps).

### MEANS TO SOLVE THE PROBLEMS

A semiconductor wafer providing method is performed by a first entity. The semiconductor wafer providing method has an acquisition step, a fabrication step, a growth step, and a wafer providing step. In the acquisition step, a remaining wafer or remaining wafers that are a semiconductor wafer part which is sliced from a semiconductor wafer having a device on a first main surface, out of the first main surface and a second main surface, and which has the second main surface is acquired from a second entity. In a fabrication step, a slice surface of the remaining wafer is fabricated. In the growth step, a semiconductor crystal layer is caused to grow on the fabricated surface of the remaining wafer. In the wafer providing step, a new semiconductor wafer having at least part of the semiconductor crystal layer, which has grown on the fabricated surface of the remaining wafer, is provided to a second entity which is the same as or different from the second entity that is an acquisition source of the remaining wafer.

### ADVANTAGEOUS EFFECTS OF THE INVENTION

The main wafer which is the semiconductor wafer part having the first main surface is used at the second entity; however, the remaining wafer which is a remaining part of the semiconductor wafer other than the main wafer can be refurbished as a new semiconductor wafer by the first entity without discarding the remaining wafer as the ground scraps.

### BRIEF DESCRIPTION OF DRAWINGS

Fig. 1 illustrates a configuration example of the entire system according to a first embodiment of the present invention;
Fig. 2 illustrates transitions of the status of a slice surface;
Fig. 3 schematically illustrates a thermal etching process in a first example of a fabrication step according to a second embodiment of the present invention;
Fig. 4 schematically illustrates a surface oxidation process in a second example of the fabrication step according to the second embodiment of the present invention; and
Fig. 5 schematically illustrates a plasma etching process in a third example of the fabrication step according to the second embodiment of the present invention.

### DESCRIPTION OF EMBODIMENTS

In the description indicated below, an "interface apparatus" may be one or more interface devices. The one or more interface devices may be at least one of the following:
- One or more I/O (Input/Output) interface devices. The I/O (Input/Output) interface device is an interface device for at least one of an I/O device and a remote display computer. The I/O interface device for the display computer may be a communication interface device. At least one I/O device may be a user interface device, for example, either one of input devices such as a keyboard and a pointing device, and output devices such as a display device.
- One or more communication interface devices. The one or more communication interface devices may be one or more communication interface devices of the same type (such as one or more NICs [Network Interface Cards]) or two or more communication interface devices of different types (such as an NIC and an HBA [Host Bus Adapter]).

Furthermore, in the description indicated below, a "memory" is one or more memory devices, which are one example of one or more storage devices, and may typically be a main storage device. At least one memory device in the memory may be a volatile memory device or a nonvolatile memory device.

Furthermore, in the description indicated below, a "persistent storage apparatus" may be one or more persistent storage devices which are one example of one or more storage devices. The persistent storage device may be typically a nonvolatile storage device (such as an auxiliary storage device) and may be specifically, for example, an HDD (Hard Disk Drive), an SSD (Solid State Drive), an NVME (Non-Volatile Memory Express) drive, or an SCM (Storage Class Memory).

Furthermore, in the description indicated below, a "storage device" may be a memory and at least a memory for the persistent storage apparatus.

Furthermore, in the description indicated below, a "processor" may be one or more processor devices. At least one processor device may be typically a microprocessor device like a CPU (Central Processing Unit), but may be a processor device of a different type like a GPU (Graphics Processing Unit). At least one processor device may be of a single-core type or a multi-core type. At least one processor device may be a processor core. At least one processor device may be a processor device in a broad sense such as a circuit which is an aggregate of gate arrays by means of hardware description languages for performing a part or whole of processing (such as an FPGA [Field-Programmable Gate Array], CPLD [Complex Programmable Logic Device], or ASIC [Application Specific Integrated Circuit]).

Furthermore, in the description indicated below, a function may be sometimes described by an expression like "yyy unit"; however, the function may be implemented by execution of one or more computer programs by a processor, or may be implemented by one or more hardware circuits (such as FPGA or ASIC), or may be implemented by a combination of the above. If the function is implemented by the execution of a program by the processor, specified processing is performed by using, for example, storage devices and/or interface devices as appropriate and, therefore, the function may be considered as at least part of the processor. The processing explained by referring to the function as a subject may be the processing executed by the processor or an apparatus which has that processor. The program may be installed from a program source. The program source may be, for example, a program distribution computer or a computer-readable recording medium (such as a non-transitory recording medium). An explanation of each function is one example and a plurality of functions may be gathered as one function or one function may be divided into a plurality of functions.

Some embodiments of the present invention will be described below with reference to the drawings. Also, in the following description, a semiconductor wafer(s) is a SiC (silicon carbide) wafer(s); however, the present invention can be also applied to semiconductor wafers other than the SiC wafer(s). Possible semiconductor wafers other than the SiC wafer(s) may be GaN (gallium nitride), AIN (aluminum nitride) wafers, or diamond wafers.

### [First Embodiment]

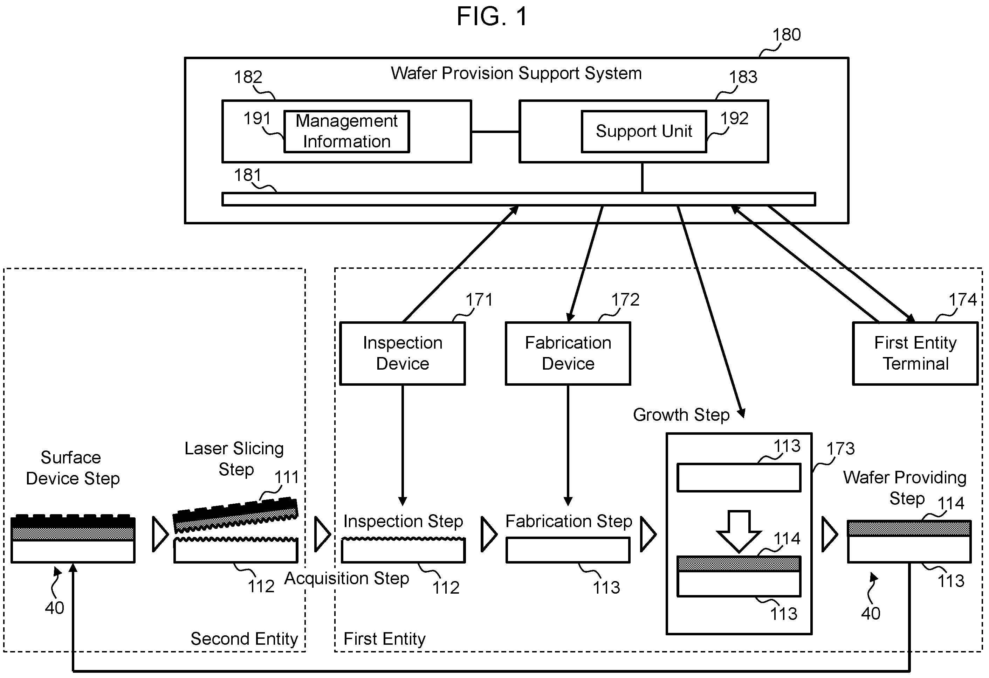

Fig. 1 illustrates a configuration example of the entire system according to a first embodiment of the present invention.

A surface device step and a laser slicing step are performed at a second entity. The second entity may be a company as a device manufacturer which retrieves SiC chips from SiC wafers 40 and provides the SiC chips or devices having the SiC chips. A SiC wafer 40 is roughly divided into a layer as base SiC crystals and a layer as growing SiC crystals (oriented SiC crystals). The growing SiC crystals have a lower BPD (basal plane dislocation) density than that of the base SiC crystals.

In the surface device step, a device is formed on a first main surface (surface) of the SiC wafer 40. The device may include electrodes and wiring patterns.

In the laser slicing step, the SiC wafer 40 having the device is sliced by a laser device along a plane direction (a direction perpendicular to a thickness direction, in other words, a direction parallel with the first main surface). Specifically, for example, the laser device applies a laser (such as a pulse laser) from a second main surface side (back side) of the SiC wafer 40 into the inside of the SiC wafer 40. Consequently, a modified layer along the plane direction is formed inside the SiC wafer 40. The SiC wafer 40 is divided, at the modified layer as a starting point, into a main wafer 111 which is a SiC wafer part having the first main surface, and a remaining wafer 112 which is a SiC wafer part having the second main surface. The main wafer 111 includes the growing SiC crystals, but does not include the base SiC crystals. The remaining wafer 112 includes the base SiC crystals and may include part of the growing SiC crystals.

An acquisition step, a fabrication step, a growth step, and a wafer providing step are performed at a first entity which is different from the second entity (moreover, in this embodiment, an inspection step is also performed between the acquisition step and the fabrication step as described later). The first entity is a company which provides a new service, that is, a company which conducts a service for acquiring (collecting) the remaining wafer 112 of the SiC wafer 40 from the second entity, causing the growing SiC crystals to grow on the remaining wafer 112 to refurbish the SiC wafer 40, and providing the refurbished SiC wafer 40 to the same second entity or a different second entity. One or more second entities exist with respect to the first entity.

In the acquisition step, the remaining wafer 112 is acquired from the second entity. In the fabrication step, the slice surface of the remaining wafer 112 is fabricated. In the growth step, the growing SiC crystals (an example of the semiconductor crystal layer) are caused to grow on the fabricated surface of the remaining wafer 112. In the wafer providing step, a new SiC wafer 40 having at least part of the growing SiC crystals which have grown on the fabricated surface of the remaining wafer 112 is provided to the same second entity as, or a different second entity from, that of an acquisition source of the remaining wafer 112.

The remaining wafer 112 can be refurbished as the new semiconductor wafer without being discarded as ground scraps, and the new semiconductor wafer can be provided to the second entity.

The fabrication step may be performed by a fabrication device 172 and the growth step may be performed by a growth device 173 (the inspection step described later may be performed by an inspection device 171). Also, a first entity terminal 174 which is an information processing terminal such as a personal computer or a smartphone may be used at the first entity.

A wafer provision support system 180 is provided, which communicates with at least one of the inspection device 171, the fabrication device 172, the growth device 173, and the first entity terminal 174 via, for example, a communication network. The wafer provision support system 180 supports the provision of the SiC wafer(s) 40. In this embodiment, the wafer provision support system 180 is a physical computer system (one or more physical computers), but may be a logical computer system (for example, a system in a cloud infrastructure) based on a physical computer system (for example, the cloud infrastructure). The wafer provision support system 180 has an interface device 181, a storage device 182, and a processor 183 connected to them.

The wafer provision support system 180 communicates with at least one of the inspection device 171, the fabrication device 172, the growth device 173, and the first entity terminal 174 via the interface device 181.

The storage device 182 stores management information 191. The management information 191 is information for managing at least part of the process from the acquisition step to the wafer providing step and, for example, includes at least part of information which is input through the interface device 181, and includes information which is output to the fabrication device 172, the growth device 173, or the first entity terminal 174, and information which becomes the basis of the above-mentioned information. Moreover, the storage device 182 stores computer programs to be executed by the processor 183.

Functions such as a support unit 192 for supporting the provision of the SiC wafer(s) 40 are implemented as the processor 183 reads the computer programs from the storage device 182 and executes them.

Of the steps at the first entity, the acquisition step, the fabrication step, the growth step, and the wafer providing step will be firstly explained below and then the inspection step will be explained later.

### <Acquisition Step>

In the acquisition step, the remaining wafer(s) 112 is acquired from one or more second entities. An arbitrary number of remaining wafers 112 may be sent to the first entity at any timing of the second entity; or regarding each of one or more second entities, an acquisition schedule including the number of the remaining wafer(s) to be acquired from the relevant second entity and acquisition time may be shared between that second entity and the first entity and the remaining wafer(s) 112 may be acquired from that second entity according to the acquisition schedule. Information indicating the acquisition schedule of each second entity may be included in the management information 191. For example, the support unit 192 may accept the input of the acquisition schedule from a second entity system (which is not shown in the drawing) or the first entity terminal 174 via the interface device 181 and store information indicating that acquisition schedule in the storage device 182. The second entity system may also be either a physical computer system or a logical computer system in the same manner as the wafer provision support system 180 and may include, for example, an information processing terminal like a personal computer at the second entity.

### <Fabrication Step>

The fabrication in the fabrication step includes grinding a slice surface (typically, grinding and/or polishing) and removing a fabrication-affected layer including the ground slice surface. The fabrication device 172 may include, for example, a device which grinds and/or polishes the slice surface (for example, a grinder), and a device which removes the fabrication-affected layer, and these devices may be an integrated device (specifically speaking, one device may be used to perform grinding and removal). For example, the fabrication device 172 may be a device which performs grinding and polishing such as a CMP (Chemical Mechanical Polishing) method.

### <Growth Step>

In the fabrication step, seed crystals 113 is obtained as a result of the fabrication of the remaining wafer 112. The seed crystal 113 may be composed of only base SiC crystals or may be composed of the base SiC crystals and part of oriented SiC crystals. At the growth device 173, growing SiC crystals (oriented SiC crystals) 114 are caused to grow on the seed crystal 113 (the fabricated remaining wafer). Such crystal growth may be performed by a sublimation method or a CVD (Chemical Vapor Deposition) method or by other methods.

### <Wafer Providing Step>

A new SiC wafer 40 that is composed of the seed crystal 113 (the fabricated remaining wafer) and the growing SiC crystals 114 which have grown is provided to the same second entity as, or a different second entity from, an acquisition source of the remaining wafer which is the base of the relevant SiC wafer. Accordingly, the acquired remaining wafer 112 is refurbished as the above-described new SiC wafer 40, so that the main wafer can be obtained from that SiC wafer 40 at the second entity. Incidentally, in the wafer providing step, the support unit 192 may select a packing material for the new SiC wafer 40, and a worker may put the new SiC wafer 40 in the packing material selected by the support unit 192 and provide the new SiC wafer 40. Consequently, it is possible to reduce the fear that cracks and damage of the new SiC wafer 40 may occur during the delivery of the new SiC wafer 40 to the second entity.

The acquisition step, the fabrication step, the growth step, and the wafer providing step have been explained above.

This embodiment has the inspection step of inspecting the slice surface of the acquired remaining wafer 112 between the acquisition step and the fabrication step. The inspection step is, for example, as described below.

### <Inspection Step>

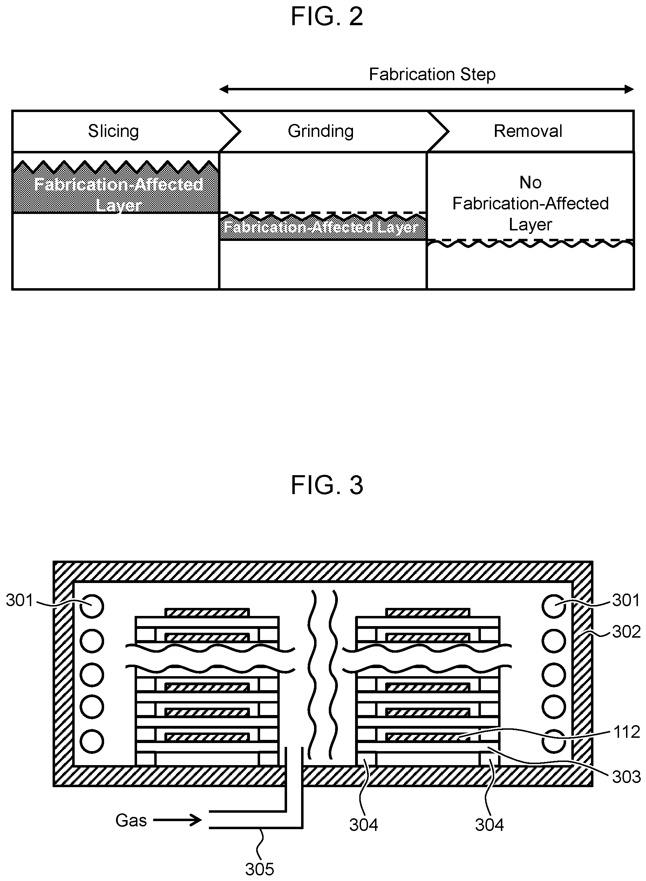

The inspection in the inspection step includes measuring at least one of a height difference of the slice surface and the thickness of the fabrication-affected layer having the slice surface. In this embodiment, both of the above are measured. The height difference of the slice surface is the height difference of an uneven shape of the surface caused by the laser irradiation in the aforementioned laser slicing step or the division into the main wafer 111 and the remaining wafer 112 (a part indicated by a jagged shape in Fig. 2 described later).

The inspection step is performed by the inspection device 171. The inspection device 171 may include a laser microscope and a Raman spectrometer. The height difference of the slice surface may be measured by the laser microscope. The thickness of the fabrication-affected layer may be measured by using the Raman spectrometer. Regarding either the height difference of the slice surface or the thickness of the fabrication-affected layer, the measurement methods do not have to be limited to the above-mentioned examples. For example, the height difference of the slice surface may be measured by a white-light interferometer or a contact-type shape measuring machine.

The support unit 192 accepts information indicating the measured height difference of the slice surface from the inspection device 171 or the first entity terminal 174 and stores that information as part of the management information 191 in the storage device 182. Also, the support unit 192 accepts information indicating the measured thickness of the fabrication-affected layer from the inspection device 171 or the first entity terminal 174 and stores that information as part of the management information 191 in the storage device 182.

At least one of the following (x) and (y) may be performed.
(x) The fabrication in the fabrication step includes deciding a grinding amount of the slice surface based on at least one of the measured height difference of the slice surface and the measured thickness of the fabrication-affected layer of the acquired remaining wafer 112 and grinding the slice surface according to the decided grinding amount. Consequently, the slice surface fabrication can be performed appropriately (with little excess or deficiency) according to the quality (status) of the acquired remaining wafer 112. Specifically, for example, the support unit 192 decides the grinding amount of the slice surface based on the information indicating at least one of the measured height difference of the slice surface and the measured thickness of the fabrication-affected layer (the information in the management information 191) and stores the information of the decided grinding amount as part of the management information 191 in the storage device 182. For example, if a PV value (maximum valley depth) is measured as an example of the height difference of the slice surface and the fabrication-affected layer depth is measured as an example of the thickness of the fabrication-affected layer, the grinding amount may be as follows: the grinding amount = the PV value + (the fabrication-affected layer depth × N). N may be an arbitrary value larger than 0 (for example, an arbitrary natural number). The support unit 192 may output the information indicating the grinding amount to the first entity terminal 174 and respond to an operation from a worker who has seen that grinding amount; and the fabrication device 172 may perform the slice surface fabrication according to the grinding amount. Alternatively, the support unit 192 may input a fabrication command associated with the information indicating the grinding amount to the fabrication device 172 (or a control device for the fabrication device 172) and the fabrication device 172 may thereby perform the slice surface fabrication according to the grinding amount. The "grinding amount" may be defined by a parameter value regarding each of one or more parameter items. For example, duration of the fabrication by the fabrication device 172, power of the fabrication (such as a temperature and pressure), etc., may be adopted as examples of the parameter items.
(y) In the growth step, the thickness of the growing SiC crystals to be caused to grow is decided based on at least one of the measured height difference of the slice surface and the measured thickness of the fabrication-affected layer of the remaining wafer 112 and the growing SiC crystals are caused to grow as much as the decided thickness. Consequently, the crystal growth can be performed appropriately (with little excess or deficiency) according to the quality (status) of the acquired remaining wafer 112. Specifically, for example, the support unit 192 decides the thickness of the growing SiC crystals to be caused to grow based on the information indicating at least one of the measured height difference of the slice surface and the measured thickness of the fabrication-affected layer information (the information in the management information 191) and stores the information of the decided thickness (to what degree of thickness the growing SiC crystals should be caused to grow) as part of the management information 191 in the storage device 182. For example, the thickness to be caused to grow may be decided based on at least one of X, Y, Z, and α. Specifically, for example, the thickness to be caused to grow may be X-Y+Z+α. X may be a required thickness when starting the surface device step or the laser slicing step at the second entity (the thickness required by the second entity). Y may be the thickness of the growing SiC crystals when received at the first entity. Z may be the grinding amount decided in the above-mentioned (x). The letter α may be an arbitrary value (for example, approximately 50 µm) decided as a fabrication allowance (fabrication margin) for removing the unevenness after the growth for the purpose of planarization. The support unit 192 may output the information indicating the relevant thickness to the first entity terminal 174 and respond to an operation from a worker who has seen that thickness; and the growth device 173 may cause the growing SiC crystals to grow as much as that thickness on the seed crystal. Alternatively, the support unit 192 may input a crystal growth command associated with the information indicating the thickness to be caused to grow to the growth device 173 (or a control device for the growth device 173) and the growth device 173 may thereby cause the growing SiC crystals to grow as much as that thickness on the seed crystal.

### [Second Embodiment]

A second embodiment will be explained. When doing so, the difference(s) between the second embodiment and the first embodiment will be mainly explained and an explanation about what the second embodiment and the first embodiment have in common will be omitted or simplified.

In the second embodiment, the crystal growth in the growth step is performed by using a method disclosed in a prior application WO2023/067736 by the same applicant as that of the present application (the above-described method will be hereinafter referred to as an "NGK method" for convenience based on the notation of the applicant). Specifically speaking, in the growth step, SiC single crystals as a seed crystal and a SiC powder layer in a state of being in contact with each other are placed within a container and a heat treatment is performed by placing the container in a firing furnace, thereby causing the SiC single crystals to grow on the seed crystal. If the NGK method is employed, it is possible to obtain the SiC single crystals (growing SiC crystals) which have a smaller BPD density than that by the sublimation method and which has the BPD density of the same degree as that by the CVD method. The second embodiment can incorporate by reference the entire or part of the technology disclosed in WO2023/067736.

Incidentally, when the crystal growth is performed by the NGK method, the fabricated surface may have lower flatness as compared to the case when the crystal growth is performed by the sublimation method or the CVD method; and, for example, the fabricated flat surface does not have to be completely flat as illustrated in Fig. 2. Specifically, for example, this is explained below.

When homoepitaxial growth is caused on the seed crystal by the sublimation method or the CVD method, essential conditions are normally that the surface to grow should be flat at the atomic level and no fabrication-affected layer should exist. Otherwise, the epitaxially grown surface may become uneven and defects such as dislocations may be generated in the crystals.

Meanwhile, the SiC wafer is rigid and is stable against heat and chemicals. So, when the surface planarization and the fabrication damage removal are performed by the CMP method after slicing and grinding, it is extremely time-consuming and a consumption amount of polishing slurry, polishing pads, etc., is large.

Therefore, in the fabrication step in this embodiment, the fabrication-affected layer is removed by a thermal etching process, a surface oxidation process, or a plasma etching process (that is, any arbitrary process with low flatness after etching than the etching by the CMP method). An explanation will be provided below about examples of the respective processes regarding the removal of the fabrication-affected layer in the fabrication step according to the second embodiment. Incidentally, in this embodiment, etching other than the thermal etching process, the surface oxidation process, and the plasma etching process, for example, the etching by the CMP method may be performed or etching by other etching processes (such as hydrogen etching) may be performed.

Fig. 3 schematically illustrates the thermal etching process.

The fabrication device 172 may include a device for removing the fabrication-affected layer by the thermal etching process. The above-described device is a device illustrated as an example in Fig. 3. In the thermal etching process, about several µm of the surface of the remaining wafer (including the fabrication-affected layer) heated and fabricated at an electric furnace 302 is sublimated.

For example, a gas (for example, an inert gas such as nitrogen or argon) is introduced via a gas pipe 305 into the electric furnace 302 which is composed of an insulation material and is provided with a heater 301, so that the inside of the electric furnace 302 becomes an inert gas atmosphere. The inside of the electric furnace 302 may be set as a vacuum atmosphere.

Heating is performed by the heater 301 and the highest heat treatment temperature is a temperature within a certain temperature range (for example, the range from 1000°C to 2000°C) and a temperature in consideration of a required etching amount may be set (for example, 1800°C may be set). Moreover, the highest temperature keeping time is an amount of time within a certain time range (for example, from one minute to 5 hours) and the amount of time in consideration of the required etching amount may be set (for example, one hour may be set). The "required etching amount," the "highest heat treatment temperature," and the "highest temperature keeping time" may respectively be examples of at least one element of the grinding amount and may be decided by the support unit 192 based on the measured thickness of the fabrication-affected layer.

The remaining wafer(s) 112 (for example, the remaining wafer 112 whose surface is ground) may be placed on a setter 303 (such as graphite) on spacers 304 (such as graphite) or may be located by using, for example, a pod composed of a heat-resistant material.

If the surface of the remaining wafer 112 is carbonized after this thermal etching process, the carbonized layer on the surface may be removed by separately performing annealing by an atmospheric atmosphere furnace or the like, or the carbonized layer on the surface may be removed by fabrication such as polishing. A carbon getter material such as Ta may be placed within the electric furnace 302 in order to prevent the carbonization of the surface.

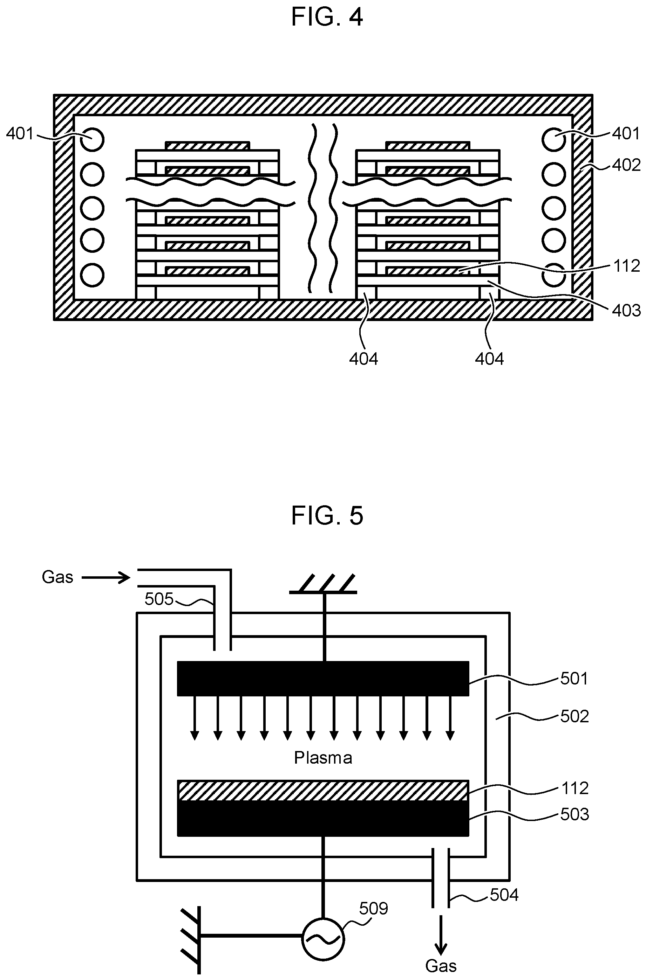

Fig. 4 schematically illustrates the surface oxidation process.

The fabrication device 172 may include a device for removing the fabrication-affected layer by the surface oxidation process. The above-described device is a device illustrated as an example in Fig. 4. In the surface oxidation process, the surface of the remaining wafer (including the fabrication-affected layer) which is heated and fabricated at an electric furnace 402 in an oxidative atmosphere (including an atmospheric atmosphere) is oxidized to the thickness of about several µm. An oxidized film may be removed by fabrication such as polishing or may be caused to volatilize or melt (reaction with raw power) upon the crystal growth.

For example, at the electric furnace 402 which is composed of an insulation material and is provided with a heater 401, the highest heat treatment temperature is a temperature within a certain temperature range (for example, the range from 800°C to 2000°C) and a temperature in consideration of a required etching amount may be set (for example, 1400°C may be set). Moreover, the highest temperature keeping time is an amount of time within a certain time range (for example, from 5 minutes to 50 hours) and the amount of time in consideration of the required etching amount may be set (for example, one hour may be set). The "required etching amount," the "highest heat treatment temperature," and the "highest temperature keeping time" may respectively be examples of at least one element of the grinding amount and may be decided by the support unit 192 based on the measured thickness of the fabrication-affected layer.

The remaining wafer(s) 112 (for example, the remaining wafer 112 whose surface is ground) may be placed on a setter 403 (such as alumina) on spacers 404 (such as alumina).

Fig. 5 schematically illustrates the plasma etching process.

The fabrication device 172 may include a device for removing the fabrication-affected layer by the plasma etching process. The above-described device is a device illustrated as an example in Fig. 5. In the plasma etching process, about several µm of the fabricated surface of the remaining wafer (including the fabrication-affected layer) undergoes the etching fabrication.

Examples of the plasma etching include RIE (Reactive Ion Etching), ECR (Electron Cyclotron Resonance), ICP (Inductively Coupled Plasma), CCP (Capacitively Coupled Plasma), etc.; however, there is no limitation and, for example, the RIE can be applied.

A substrate temperature, a gas type, processing time, and a device configuration may be set as appropriate according to a desired etching rate and a surface state. Regarding the remaining wafer surface, deposits or the like on the surface may be removed in advance by, for example, ashing.

There are an upper electrode 501 and a lower electrode 503 within a chamber 502, a gas is introduced from a gas introduction pipe 505, the gas is caused to exit from a gas exhaust pipe 504, and plasma is generated between the electrodes 501 and 503 by a high-frequency power source 509s.

Examples of the respective processes regarding the removal of the fabrication-affected layer in the fabrication step according to the second embodiment have been explained. Incidentally, regarding the crystal growth, for example, there are also differences described below between the sublimation method, the CVD method, and the NGK method.

Specifically speaking, the sublimation method and the CVD method require precision cleaning after the Chemical Mechanical Polishing (CMP) and before the formation of an epitaxial layer, while the NGK method does not require such cleaning.

Moreover, heating rates of the sublimation method and the CVD method are fast, thereby increasing the possibility that warpage of the seed crystal may damage the seed crystal. Furthermore, regarding the sublimation method and the CVD method, a plurality of seed crystals can be put in the chamber of the growth device; however, if even only one seed crystal is damaged, that will affect other seed crystals. On the other hand, regarding the NGK method, its heating rate is slower than that of the sublimation method or the CVD method, so that even if the seed crystal has some warpage, there is a low possibility that such warpage may cause damage. Furthermore, in the case of the NGK, one seed crystal is placed in one container, so that even if the seed crystal is damaged, that will not affect other seed crystals.

Furthermore, in either the second embodiment or the first embodiment, the diameter of the remaining wafer 112 acquired by the acquisition step may be 6 inches or more and, for example, the diameter of the remaining wafer may also be 8 inches or more (for example, in the second embodiment). For example, when the diameter is either 6 inches or 8 inches, the thickness of the main wafer 111 may be approximately 100 µm; however, if the diameter is 6 inches, the thickness of the remaining wafer 112 may be approximately 250 µm; and if the diameter is 8 inches, the thickness of the remaining wafer 112 may be approximately 400 µm.

### [Third Embodiment]

A third embodiment will be explained. When doing so, the difference(s) between the third embodiment and the first to second embodiments will be mainly explained and an explanation about what the third embodiment and the first to second embodiments have in common will be omitted or simplified.

A schedule decision step is performed. In the schedule decision step, a growth schedule of the growing SiC crystals on the fabricated surface of the remaining wafer 112 is decided by, for example, the support unit 192 on the basis of the acquisition schedule regarding each of one or more second entities. The growth step is performed based on the growth schedule. Consequently, it is expected to efficiently refurbish and provide the SiC wafers. For example, if the acquisition schedule from a first second entity is to "acquire 100 remaining wafers, each of which has the diameter of 6 inches, during period X" and the acquisition schedule from a second second entity is to "acquire 200 remaining wafers, each of which has the diameter of 8 inches, during the period X," the growth schedule for a total of 300 remaining wafers 112 may be decided based on these acquisition schedules. Specifically speaking, the growth schedule may be decided based on a combination of acquisition times indicated by the acquisition schedules of the respective second entities, the number of the remaining wafers 112 to be acquired, and the diameters of the remaining wafers 112 to be acquired. Moreover, the growth schedule may be decided based on, other than the acquisition schedules of the respective second entities, the physical distances between the second entities and the first entity and/or other elements.

Specifically, for example, the growth schedule may be decided based on at least one of the following (1) through (3):
(1) the required growth thickness based on the information about the remaining wafer 112 (for example, the thickness decided in the aforementioned (y));
(2) information about the second entity which is an acquisition source and/or a provision destination of the remaining wafer 112 (for example, information indicating at least one of the second entity's name, information about the SiC wafer used by or to be used by the second entity (such as a wafer manufacturer, grades, shape parameters (such as warpage), quality (such as defect density)), and specifications required by the second entity); and
(3) fabrication conditions for the fabrication step (for example, conditions according to the required fabrication thickness and surface state that are identified based on the information of the acquired remaining wafer 112).

Specifically, for example, when deciding the growth schedule, for example, the following procedures may be taken. Specifically speaking, the support unit 129 identifies the maximum value of the required growth thickness obtained in the above-mentioned (1) from among all the remaining wafers where the crystal growth will be performed. Based on this information (the maximum value of the required growth thickness), the support unit 129 decides the highest temperature and retention time upon the crystal growth (at the same time, the support unit 129 may also decide a retrieval day and time, a fabrication day and time, etc.). Moreover, based on the above-mentioned (2) and (3), the support unit 129 decides target quality of each remaining wafer (for example, warpage, crystal defects, a surface roughness state, etc.), and decides parameters (such as a heating rate, a cooling rate, and pod arrangement) for controlling the crystal quality based on the decided target quality of the relevant remaining wafer with respect to each of the remaining wafers. The support unit 129 calculates the growth schedule which makes it possible to optimize the crystal growth thickness and the quality (such as the warpage, the crystal defects, and the surface roughness state) from the information identified and decided in the above-described manner.

### [Fourth Embodiment]

A fourth embodiment will be explained. When doing so, the difference(s) between the fourth embodiment and the first to third embodiments will be mainly explained and an explanation about what the fourth embodiment and the first to third embodiments have in common will be omitted or simplified.

A classification step is performed. In the classification step, regarding each of the plurality of the acquired remaining wafers 112, for example, the support unit 192 assigns a group ID of the relevant remaining wafer to that remaining wafer 112 based on wafer information including information indicating at least one of the second entity which is the acquisition source of the relevant remaining wafer 112 (for example, the second entity's name and postal address) and the quality of that remaining wafer 112 (for example, the quality identified by the inspection step and/or the quality after the fabrication step). Regarding each group ID, one or more remaining wafers to which the relevant group ID is assigned is a set of remaining wafers with the same or similar characteristics of the wafer information. Each remaining wafer 112 undergoes the fabrication step and/or a step(s) after the fabrication step based on the group ID assigned to the relevant remaining wafer 112. For example, the remaining wafer(s) 112 may be stored at a place according to the assigned group ID. Moreover, the wafer information may include at least one of the second entity's name, a manufacturer of the seed crystal, a quality level of the seed crystal, thicknesses of the wafer and the growing SiC crystals before the fabrication or after the fabrication, and the required grinding amount. The support unit 192 may plan a schedule by considering how to achieve good efficiency by deciding which wafers should be put in the same group to fabricate them and cause them to grow, based on the wafer information of each remaining wafer 112, and then may proceed with subsequent processing on a group basis. Consequently, it is expected that variations between the respective wafers due to the fabrication and the growth can be minimized and fabrication time and growth time can be optimized. Of the wafer information, information indicating the shapes, shapes, and thicknesses regarding the wafers may be used as criteria for classification (grouping) and the classification may be performed based on information about the second entities (for example, names and postal addresses of the second entities).

### [Fifth Embodiment]

A fifth embodiment will be explained. When doing so, the difference(s) between the fifth embodiment and the first to fourth embodiments will be mainly explained and an explanation about what the fifth embodiment and the first to fourth embodiments have in common will be omitted or simplified.

An information providing step is performed. In the information providing step, for example, the support unit 192 provides information to each of one or more second entities (for example, to a second entity system for the relevant second entity (such as a second entity terminal)). The information to be provided includes information indicating at least one of the following (1) through (3):
(1) progress in the process until the new SiC wafer 40 from the remaining wafer 112 is provided to the relevant second entity;
(2) if any defect is detected during the process, an identified or estimated cause regarding that defect; and
(3) of a first inspection result regarding the quality of the remaining wafer 112 and a second inspection result regarding the quality of the new SiC wafer 40 obtained from that remaining wafer 112 and provided to the relevant second entity, at least the second inspection result.

Consequently, the second entity can identify, for example, when it will be possible to receive the new SiC wafer 40, the quality of the received SiC wafer 40, the control of laser slicing, and so on. Moreover, slicing conditions can be improved at the second entity by sharing information about the depth of the fabrication-affected layer of the acquired remaining wafer 112 (for example, including a crack depth, etc.), an amount of chipping, scratches, etc., caused by the slicing, and crystal defects and their variations; and, therefore, improvements in fabrication time, growth time, and yield at the first entity can be expected. Furthermore, information about the yield at the first entity may be provided to the second entity and a contract or others between the first entity and the second entity may be adjusted based on that information.

### [Sixth Embodiment]

A sixth embodiment will be explained. When doing so, the difference(s) between the sixth embodiment and the first to fifth embodiments will be mainly explained and an explanation about what the sixth embodiment and the first to fifth embodiments have in common will be omitted or simplified.

The SiC wafer 40 to be provided may be, instead of the SiC wafer 40 having the growing SiC crystals 114 and the seed crystal 113, a wafer as a growing SiC crystal part which is sliced from the growing SiC crystals grown on the fabricated surface of the remaining wafer 112. Specifically speaking, practically, a wafer as a substrate of the main wafer may be provided.

Moreover, another growth step may be performed after the wafer providing step. In the other growth step, the growing SiC crystals may be caused to grow on a wafer as a part other than the sliced growing SiC crystals part (an example of the semiconductor crystal layer part) (for example, a wafer which is composed of at least the seed crystal out of the rest of the growing SiC crystals and the seed crystal). The other growth step may be performed by the growth device 173.

An embodiment has been described above; however, this is merely an illustrative example to explain the present invention and there is no intention to limit the scope of the present invention to this embodiment. Furthermore, the present invention can be also executed in other various forms. For example, two or more arbitrary embodiments from among the aforementioned embodiments may be combined together.

### REFERENCE SIGNS LIST

- 171:: inspection device
- 172:: fabrication device
- 173:: growth device
- 174:: first entity terminal
- 180:: wafer provision support system

## Claims

1. A semiconductor wafer providing method performed by a first entity, the method comprising:
an acquisition step of acquiring, from a second entity, a remaining wafer that are a semiconductor wafer part which is sliced from a semiconductor wafer having a device on a first main surface, out of the first main surface and a second main surface, and which has the second main surface;
a fabrication step of fabricating a slice surface of the remaining wafer;
a growth step of causing a semiconductor crystal layer to grow on the fabricated surface of the remaining wafer; and
a wafer providing step of providing a new semiconductor wafer having at least part of the semiconductor crystal layer, which has grown on the fabricated surface of the remaining wafer, to a second entity which is the same as or different from the second entity that is an acquisition source of the remaining wafer.

2. The semiconductor wafer providing method according to claim 1,
comprising an inspection step of inspecting the slice surface between the acquisition step and the fabrication step,
wherein the inspection in the inspection step includes measuring at least one of a height difference of the slice surface and a thickness of a fabrication-affected layer having the slice surface; and
wherein the fabrication in the fabrication step includes deciding a grinding amount of the slice surface based on at least one of the measured height difference of the slice surface and the measured thickness of the fabrication-affected layer and grinding the slice surface according to the decided grinding amount.

3. The semiconductor wafer providing method according to claim 2,
wherein the decided grinding amount is a value obtained by adding the measured height difference of the slice surface to a product of the measured thickness of the fabrication-affected layer and an arbitrary value.

4. The semiconductor wafer providing method according to claim 1,
comprising an inspection step of inspecting the slice surface between the acquisition step and the fabrication step,
wherein the inspection in the inspection step includes measuring at least one of a height difference of the slice surface and a thickness of a fabrication-affected layer having the slice surface; and
wherein in the growth step, a thickness of the semiconductor crystal layer to be caused to grow based on at least one of the measured height difference of the slice surface and the measured thickness of the fabrication-affected layer and the semiconductor crystal layer is caused to grow as much as the decided thickness.

5. The semiconductor wafer providing method according to claim 4,
wherein the fabrication in the fabrication step includes deciding a grinding amount of the slice surface based on at least one of the measured height difference of the slice surface and the measured thickness of the fabrication-affected layer and grinding the slice surface according to the decided grinding amount; and
wherein the decided thickness is a thickness obtained by subtracting a sum of a thickness of the semiconductor crystal layer when received by the first entity, the decided grinding amount, and an arbitrary value from a thickness required by the second entity.

6. The semiconductor wafer providing method according to claim 4,
comprising a schedule decision step including the following processing for:
(a) identifying a maximum value of the decided growth thickness from among all the remaining wafers in each of which the semiconductor crystal layer is caused to grow;
(b) deciding a highest temperature and retention time during the crystal growth based on the identified maximum value of the growth thickness;
(c) deciding target quality of each remaining wafer based on information indicating warpage and/or quality of a wafer used or to be used by a second entity which is the acquisition source and/or a provision destination of the remaining wafer, and information indicating a fabrication condition for the fabrication step;
(d) deciding a parameter for controlling crystal quality based on the decided target quality of the remaining wafer regarding each remaining wafer; and
(e) calculating a growth schedule that is a schedule for optimization of the crystal growth thickness and the quality and is a schedule of growth of semiconductor crystals on the fabricated surface of the remaining wafer, from the information identified or decided in the above-described (a) through (d).

7. The semiconductor wafer providing method according to claim 1,
comprising a schedule decision step of deciding, regarding each of one or more second entities, a growth schedule of semiconductor crystals on the fabricated surface of the remaining wafer based on an acquisition schedule including a quantity of the remaining wafers acquired from the second entity and acquisition time,
wherein the growth step is performed based on the decided growth schedule.

8. The semiconductor wafer providing method according to claim 1,
comprising a classification step of assigning, regarding each of a plurality of acquired remaining wafers, a group ID of that remaining wafer to the remaining wafer based on wafer information including information indicating at least one of the second entity which is the acquisition source of the remaining wafer, and quality of the remaining wafer,
wherein regarding each group ID, one or more remaining wafers to which that group ID is assigned is a set of remaining wafers with same or similar characteristics of the wafer information; and
wherein each remaining wafer performs the fabrication step and/or a step after the fabrication step on the basis of the group ID assigned to the remaining wafer.

9. The semiconductor wafer providing method according to claim 1,
wherein in the wafer providing step, a packing material for the new semiconductor wafer is selected, the new semiconductor is put in the selected packing material, and the new semiconductor wafer is then provided.

10. The semiconductor wafer providing method according to claim 1,
comprising an information providing step of providing information to each of one or more second entities,
wherein the information includes information indicating at least one of the following:
- progress in a process until the new semiconductor wafer from the remaining wafer is provided to the second entity,
- if any defect is detected during the process, an identified or estimated cause regarding that defect; and
- of a first inspection result regarding quality of the remaining wafer and a second inspection result regarding quality of the new semiconductor wafer obtained from that remaining wafer and provided to the second entity, at least the second inspection result.

11. The semiconductor wafer providing method according to claim 1,
wherein the semiconductor wafer is a SiC wafer; and
wherein in the growth step, SiC single crystals as seed crystals and a SiC powder layer in a state of being in contact with each other are placed within a container and a heat treatment is performed by placing the container in a firing furnace, thereby causing the SiC single crystals to grow on the seed crystal.

12. The semiconductor wafer providing method according to claim 1,
wherein the new semiconductor wafer has the remaining wafer which has been fabricated, and a semiconductor crystal layer including the semiconductor crystal layer grown on the fabricated surface of the remaining wafer.

13. The semiconductor wafer providing method according to claim 1,
wherein the new semiconductor wafer is a wafer as a semiconductor crystal layer part which is sliced from the semiconductor crystal layer grown on the fabricated surface of the remaining wafer.

14. The semiconductor wafer providing method according to claim 13,
comprising another growth step of causing a semiconductor crystal layer to grow on a wafer as a part other than the sliced semiconductor crystal layer part after the wafer providing step.

15. The semiconductor wafer providing method according to claim 1,
wherein a diameter of the remaining wafer acquired by the acquisition step is 6 inches or more.

16. The semiconductor wafer providing method according to claim 15,
wherein the diameter of the remaining wafer acquired by the acquisition step is 8 inches or more.

17. The semiconductor wafer providing method according to claim 11,
wherein the fabrication in the fabrication step includes removal by an arbitrary process with lower flatness after etching than after etching according to a CMP (Chemical Mechanical Polishing) method.

18. A semiconductor wafer providing system comprising:
a fabrication device that fabricates a slice surface of a remaining wafer acquired by a first entity from a second entity; and
a growth device that causes a semiconductor crystal layer to grow on the fabricated surface of the remaining wafer,
wherein the remaining wafer is a semiconductor wafer part which is sliced from a semiconductor wafer having a device on a first main surface, out of the first main surface and a second main surface, and which has the second main surface; and
wherein a new semiconductor wafer having at least part of the semiconductor crystal layer, which has grown on the fabricated surface of the remaining wafer, is provided to a second entity which is the same as or different from the second entity that is an acquisition source of the remaining wafer.
